# EUROPEAN PATENT SPECIFICATION

(11) **EP 2 706 367 B1**
(45) Date of publication and mention of the grant of the patent: **04.11.2015**
(21) Application number: 12183450.1
(22) Date of filing: 07.09.2012
(51) Int. Cl.: G01R 31/36, G01R 19/165, G01R 31/00, G01R 31/34

(54) **Diagnosis system for a vehicle battery charging apparatus**
Diagnosesystem für ein Fahrzeugbatterieaufladegerät
Système de diagnostic pour un dispositif de charge de batterie de véhicule

(43) Date of publication of application: 12.03.2014
(73) Proprietor: IVECO S.p.A., 10156 Torino (IT)
(72) Inventor: Varalda, Orlando, 10088 Volpiano (IT)
(74) Representative: Franzolin, Luigi

(56) References cited:
- US-A- 4 086 531
- US-A- 4 314 193
- US-A1- 2001 054 890
- US-A1- 2004 066 200
- US-B1- 6 445 158

## Description

### Application field of the invention

The present invention refers to the field of diagnosis systems for on-board vehicle components and in particular for the vehicle battery charging apparatus, including the alternator, the alternator wiring and the mechanical parts connecting the alternator to the internal combustion engine. An example of diagnostic system is given in US2004066200, whose features are in the preamble of claim 1.

### Description of the prior art

The vehicle alternator is an electric machine equipped with a rectifier, suitable to rectify the electric signal produced by the alternator, and with a voltage regulator, which controls the excitation of the electric machine as a function of the level of direct-current voltage measured at the output of such rectifier.

Some vehicles are equipped with means for measuring the battery charging status. Such value, expressed in volts, is then stored in a message of the CAN vehicle network.

When the measured value is low, an error is recorded/signalled.

Thus such voltage value is measured at each instant, without any relation between subsequent measures. Such values, instead, are compared with a threshold value.

The battery charging value can be low for three reasons:
- when the batteries are worn,
- when the alternator cannot charge them due to a malfunctioning of the alternator itself, or of the wiring, or to a fault of the mechanical connection,
- when the vehicle is used in a way that is not compliant with the specification or when it is not used at all.

As regards the latter point, think to a manipulation of the original electric system that brings to an excessive power absorption or consider, for example, to a long inactivity period when, since the vehicle is not started, batteries cannot be charged.

When the batteries have been replaced recently and the vehicle is used regularly, the cause of an inadequate battery charge identified and signalled by the on-board instruments is usually attributed to the alternator.

This implies the replacement of an expensive component, which is often perfectly working, with high costs for the manufacturer.

Moreover the manufacturer, in order to provide evidence of the faultiness of the component to the supplier, has to carry out further expensive controls.

### Summary of the invention

Therefore the aim of the present invention is to provide a system for identifying in a reliable way that an inadequate battery charging is or is not caused by the alternator. Furthermore, the system allows to identify the specific faulty portion of the alternator, namely the electromechanical one or the part related to the regulator.

The idea at the basis of the present invention is to perform efficiency tests of the vehicle battery charging system by exploiting the battery charging voltage measuring means, usually already present in the vehicle, but used only to detect and to signal a low voltage level, namely by storing a single voltage value at a time and comparing it with a reference voltage value. On the contrary, according to the present invention, two or more voltage values are stored at a time, in order to determine the progression of the battery charging. In other words, said two or more measures are compared between each other and to at least a threshold value and/or to a time interval of acquisition of said two or more voltage measures.

The object of the present invention is a diagnosis system of the vehicle battery charging apparatus, in accordance with claim 1.

The present invention is based on the determination of the trend of the voltage measured at the ends of the batteries in relation to different conditions and situations in order to determine a progression of such voltage that indicates the possible presence of failures.

Such system, as it will be clear from the following detailed description, allows to perform a certain number of tests on the system until it identifies, with a good approximation, the cause of the low voltage value of the batteries. The system that is object of the invention helps testing the different vehicle components, in order to exclude the interaction of such components, with the aforementioned detected faults. Moreover, when the alternator is faulty, the system allows to identify which of its portions is faulty, so that the vehicle manufacturer can avoid further tests for the aforementioned purposes.

The system that is object of the present invention firstly exploits the sensor measuring the battery charge, already present on the vehicle, in order to monitor the progression of the battery charging and thus the behaviour of the alternator and of the regulator. Secondly, the system aims to certify the actual malfunctioning of the alternator/regulator.

It is also object of the present invention a method for performing the diagnosis as defined in claim 6.
Another object of the present invention is a vehicle equipped with the diagnosis system that is object of the present invention as defined in claim 9, a computer program as defined in claim 10 and a computer-readable means as defined in claim 11.
The claims are an integral part of the present description.

### Brief description of the Figures

Further purposes and advantages of the present invention will become clear from the following detailed description of a preferred embodiment (and of its alternative embodiments) and the drawings that are attached hereto, which are merely illustrative and non-limitative, in which:
figure 1 shows a general flowchart of the diagnosis method that is object of the present invention.
figures 2, 3 and 4 show in detail a block of the flowchart of figure 1;
figure 5 schematically shows functional blocks of the system that is object of the present invention, performing the method of the previous figures;
figure 6 schematically shows the integration of the system of figure 5 with a vehicle battery charging apparatus.
In the figures the same reference numbers and letters identify the same elements or components.

### Detailed description of preferred embodiments of the invention

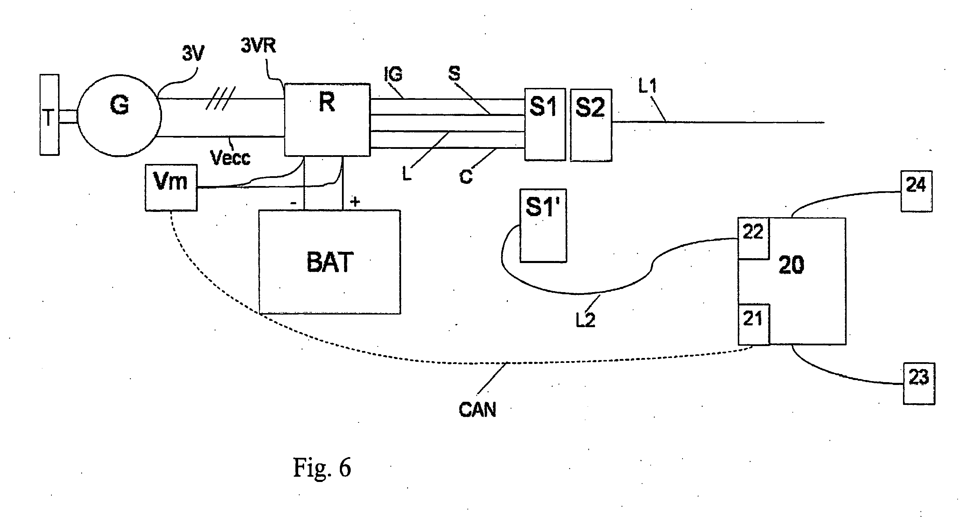

The vehicle battery charging apparatus, with reference to figure 6, comprises
- an electric generator G, connected by mechanical connection components T, typically a belt, to the heat engine, substantially to a power takeoff of the heat engine; it has a three-phase output 3V,
- a voltage regulator/rectifier R having a three-phase input 3VR connected to the three-phase output 3V of the generator; the regulator has a first output Vecc connected to an input of the generator to control the excitation of the generator; the regulator has a direct current output +/- to power the vehicle batteries BAT; the generator may have one or more connection lines among which IG, S, L and C to the vehicle electric system L1, by means of a connector S1/S2;
- measuring means Vm of the voltage at the ends of the vehicle batteries BAT and a vehicle data network CAN interfaced with said measuring means; in particular the measured data is stored and made available by the vehicle network CAN.

The connection to the vehicle electric system is made by a male/female connector S1/S2. S1 identifies the regulator side, while S2 identifies the side of the vehicle wiring L1. Vehicle wiring L1 refers to an electric wiring for analogical control signals, different and distinct from the data network CAN.

The system that is object of the present invention comprises processing means 20 having a first interface 22 connecting to the processing means to said plug S1' by means of a line L2 and a second interface 21 connecting to the vehicle data network CAN.

The system that is object of the present invention exploits the voltage measure at the ends of the batteries in a different way from the technique known in the art. In particular, the measured voltage values are compared between each other in time, both for detecting slow variations within two or more seconds, to evaluate substantially if the alternator/regulator is charging the batteries BAT, and for measuring fast variations, namely within less that one second, to evaluate power ripples possibly due to an asymmetry of the alternator G.

Thus the processing means 20 comprise first comparison means 20.1 to determine a progression of the trend of the battery voltage; second comparison means 20.2 to determine charging ripples; third comparison means 20.3 to determine voltage ripples depending on an alternate connection/disconnection of electrical load connected to the vehicle batteries BAT.

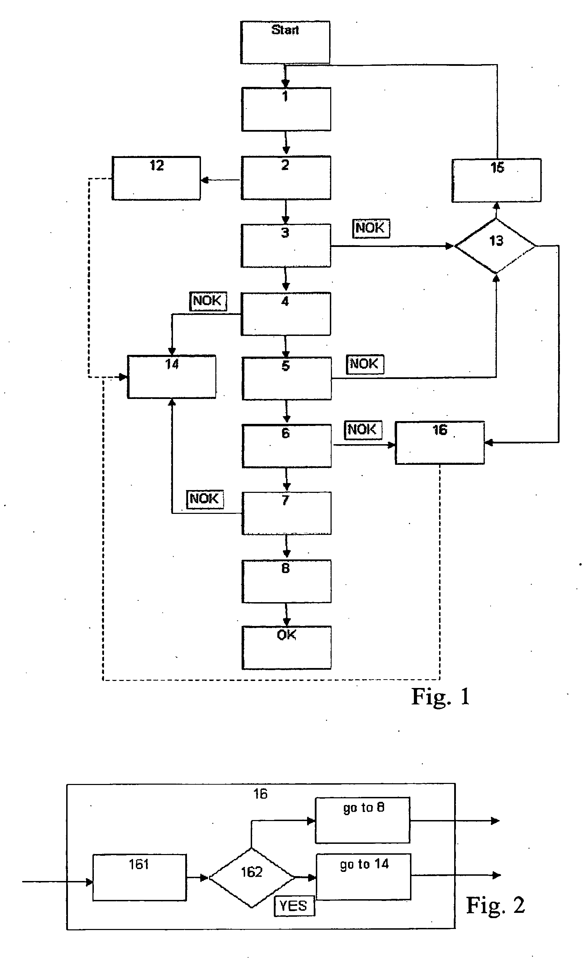

With particular reference to figure 1, step 1 indicates a functionality that is normally performed, namely the measure of the battery charging status by means of the voltage measured at the batteries poles. If the charging status is inadequate, then such voltage value is acquired as an error. According to a preferred alternative embodiment of the present diagnosis method of the battery charging system, the following steps after the first one are performed as indicated below:
- step 2: verification of the detection of a current error (namely not of an error detected and stored in the past), both with the engine stopped and with the engine started (started by an operator following an invitation shown on the display 24, or started automatically by the system), if an error is detected, the internal combustion engine is stopped - automatically or following an invitation shown on the display of the device that is object of the present invention - and an invitation is notified to verify the wiring of the alternator by means of the connection of the connector S1' to the connector S2, waiting for the results of such verification - such verification may be operated by voltmeter means, then
- step 12: if the results of such verification indicates that the origin of the error is due to the wiring (YES), the method stops, otherwise the error may be due to the alternator and the method can stop, see in the following a more detailed description of step 12;
- step 3: otherwise, if no current error, neither with engine started nor with engine stopped (step 2) is detected, then the direct-current voltage generated by the alternator is measured, namely at the direct-current output of the regulator, preferably during a first predetermined interval of time, for example longer than one second, assuming that the internal combustion engine is already running - started automatically or by an operator following an invitation - if the direct-current voltage at the output of the regulator exceeds a lower acceptability threshold, then the test is considered as passed and step 4 is performed, otherwise (NOK (not ok)), step 13 is performed;
- step 4: verification of the alternator symmetry; this implies that the system has means suitable to
   - be connected to the field winding of the alternator to compare the respective wave forms and/or
   - be connected to the output of the rectifier and measure the voltage ripples;
   if the comparison shows an acceptable difference between the steps or a ripple of the direct-current signal within a predetermined ripple interval, the present test is considered as passed and step 5 is performed, otherwise (NOK (not ok)) step 14 is performed;
- step 5: monitoring of the direct-current voltage generated by the alternator, namely measured at the direct-current output of the regulator, in order to verify its stability within a second predetermined interval of time; even though said stabilization occurs within said second interval of time, the present test is considered as passed and step 6 is performed, otherwise (NOK (not ok)) step 13 is performed;
- step 6: verification of the stability of the regulation of the voltage regulator by the alternated connection/disconnection of electrical loads - started by the operator following an invitation shown on the display 24 or started automatically by the system - in particular measurement of the direct-current voltage generated by the alternator with the electrical load connected, if the direct-current voltage exceeds said lower acceptability threshold then the test is considered as passed and step 7 is performed, otherwise (NOK (not ok)) and step 14 is performed;
- step 7: Measurement of the direct-current voltage generated by the alternator, this implies that the internal combustion engine is always working, if the direct-current voltage is lower (or equal) to an upper acceptability threshold then the test is considered as passed and step 8 is performed, otherwise (NOK (not ok)) and step 14 is performed;
- step 8: verification of the presence of an error stored in the control unit, namely detected and stored in the past, if an error related to the charging system was stored, it is removed from the memory, since it is evident that the error depends on conduction faults of the wiring or on problems of the mechanical connection T of the alternator G, anyway if the present step is reached, the present method is considered as positively finished (OK) and the operator is invited to perform further controls on the wiring and on the mechanical connection of the alternator;
- step 13: if the direct-current voltage measured at step 3 DOES NOT exceed said lower acceptability threshold, or if the direct-current voltage measured at step 3 DOES NOT stabilize and (AND) the present step is performed for the first time then
- step 15: the operator is invited to charge the batteries or to replace them with reliably efficient ones while the system waits for an input signal to restart the method from step 1, otherwise if the present step 15 has already been performed during a previous run of the present diagnosis method, then
- step 16:
   - if the batteries are reliably efficient and
   - the measure of the direct-current voltage generated by the alternator is lower than said predetermined lower threshold (step 3 NOK) or
   - if said voltage does not stabilize (step 6 NOK), then a mechanical connection problem of the alternator or an alternator problem is signalled.
When the present method reaches step 16, namely when it signals a problem of the mechanical connection of the alternator or a malfunctioning of the alternator itself, the method can go on with step 161 and
- such signal is shown
- the heat engine is automatically stopped or a technician is invited to do so by a message shown on the display 24,
- the technician is invited to verify the mechanical connection of the alternator and after that the system waits for an input by the technician, confirming that the correct mechanical connection of the alternator has been verified;
- step 162, if such input is positive, namely if the mechanical connection of the alternator is working properly (162 YES), then step 14 is performed to report a fault of the alternator, otherwise (162 NOT) step 8 is performed to remove possibly stored errors and to end the present diagnosis method with a positive result.

At step 12, if the wiring verification identifies a problem due to the alternator, then it provides a printed message certifying the malfunctioning of the component, including an identification code of the vehicle, otherwise a problem in the wiring is identified.

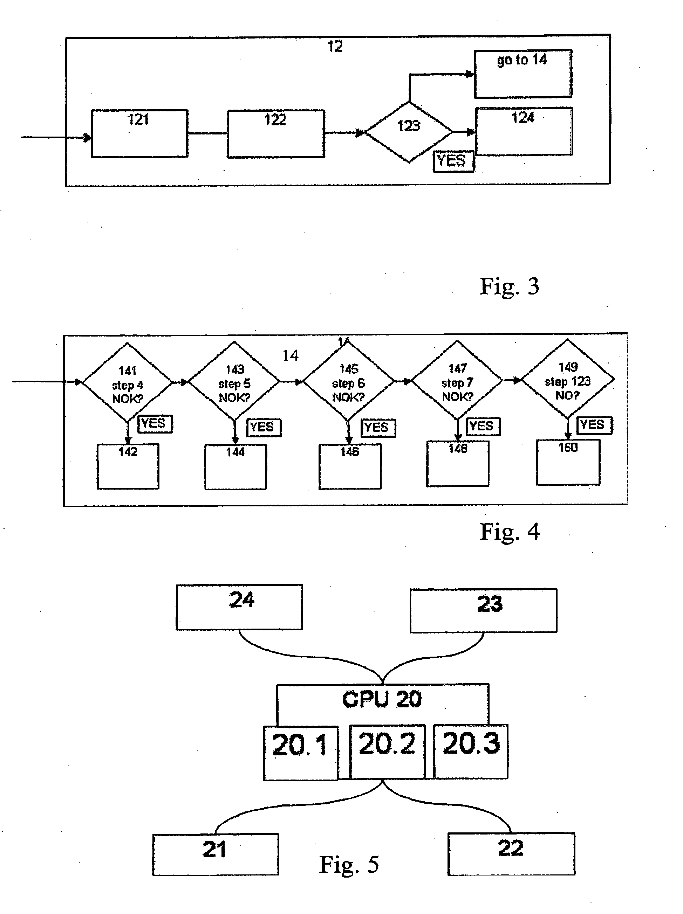

With reference to figure 3, step 12 is now described in detail:
At step 121 the system requires that the electric connector connecting the alternator to the wiring L1 of the vehicle is unplugged and that the interface 22 of the processing means 20 is connected to such connector, by means of the appropriate connector S1', in order to verify the continuity of, respectively, the supply line of the regulator IG, of the measurement line of the direct-current output of the rectifier S, of the excitation line L of the electric machine and, possibly, of the control line C of the regulator by the on-board control unit ECU.

As an alternative, the system may provide bypass means in order to bypass the alternator and perform the aforementioned verification.

At step 122 voltmeter continuity tests are performed on the aforementioned lines.

At step 123, if only one of the lines is interrupted or faulty, then, at step 124, the method ends by signalling a problem on the specific faulty line, otherwise step 14 is performed, wherein the method ends by certifying a problem of the alternator.

Thus it can be understood that step 12, in case of a malfunctioning of the alternator, is followed by step 14. And thus it can be understood, that the output block for any malfunctioning of the alternator is step 14.

If step 14 is reached because the direct-current voltage generated by the alternator is lower than said predetermined lower threshold (step 3 NOK), then a printed message certifies the malfunctioning of the component, including an identification code of the vehicle.

With reference to figure 4, if step 14 is reached because the alternator steps are not symmetrical (step 4 NOK), then, step 142, a printed message is provided certifying the malfunctioning of the component, including an identification code of the vehicle and, preferably that the problem identified may be due to a fault of the field winding or of the diodes of the rectifier.

Moreover, if step 14 is reached because the voltage did not stabilize within said second predetermined interval of time (step 5 NOK), then, step 144, a printed message is provided certifying the malfunctioning of the component, including an identification code of the vehicle and, preferably that the problem identified may be due to a fault of the field winding or of the rotor or of the regulator.

Moreover, if step 14 is reached because of the lack of adjustment stability by the voltage regulator R, namely if the direct-current voltage generated is not at least equal to said lower acceptability threshold, even after the alternate connection/disconnection of electrical loads (step 6 NOK), then, step 146, a printed message is provided certifying the malfunctioning of the component, including an identification code of the vehicle and, preferably that the problem identified may be due to a fault of the field winding or of the diodes or of the brushes.

Moreover, if step 14 is reached because the direct-current voltage is not lower than said upper acceptability threshold (step 7 NOK), then, step 148, a printed message is provided certifying the malfunctioning of the component, including an identification code of the vehicle and, preferably that the problem identified may be due to a fault of the regulator.

Moreover, if step 14 is reached from step 12, namely after having verified that the connection lines of the alternator are intact, then, step 150, a printed message is provided certifying the malfunctioning of the component, including an identification code of the vehicle and, preferably that the problem identified may be due to a fault of the voltage regulator or of the brushes or of the field winding.

As an alternative to the printed message, the certification may be automatically sent to a remote dedicated server of the vehicle manufacturer.

According to a preferred alternative embodiment of the invention, said lower acceptability threshold is about 13.8V or 27.6V, depending on the nominal voltage of the electric system, 12V or 24V respectively; the upper threshold being 15V or 30V respectively; said difference between the phases may be expressed by a percentage of the respective voltages, namely 10%, or said acceptable signal ripple of direct current lower than 5%; said first interval of time (relating to step 3) may be comprised, for example between 0 and 20s, said second interval of time (relating to step 5) may be comprised between 0 and 40s.

With particular reference to figure 5, the present invention may be realized by means of a device comprising processing means 20 having an interface to the vehicle data network, generally CAN, to acquire the detection of static and/or dynamic errors, and to acquire and sample said direct-current voltage measures generated by the regulator/rectifier, means for storing said measures and timing means to measure said intervals of time.

Moreover the device may comprise an analogical interface 22 to the vehicle wiring to perform said continuity tests on lines IG, L and S and on the possible additional control line C of the regulator.

Furthermore, the device comprises a human/machine interface 24 or means for interfacing with a human/machine interface, for example already present on-board, in order to send messages/requests to a technician, when, for example, he/she is invited to verify the mechanical connection of the alternator.

Moreover the device comprises output means 23 to certify the malfunctioning of the alternator: they may comprise a printer or a remote connection implementing protocols per se known, to send said certification to the vehicle manufacturer.

Said processing means 20 may be integrated in their own case and define a specially provided tool or they may be at least partially integrated in a vehicle control unit, so that the human/machine interface means may be selected among the ones already present on board of the vehicle.

As regards the analogical interface to verify the continuity of the connection lines of the alternator, or to verify the bypass means, controlled by the processing means 20, it is preferable to use the connector S1' compatible with the vehicle connector S2, in order to manually operate a disconnection and a connection. This is because the operation of connection and disconnection of the connector of the vehicle wiring S2 with the connector S1' of the interface 22 may determine the cleaning of the electrical contacts, restoring the correct functioning of the vehicle wiring with the alternator/regulator.

In this case, the system invites the technician to exchange the connectors and it waits for a respective confirmation input before performing the voltmeter tests described with reference to figure 3.

In case one wants to monitor directly the three phases of the alternator, the system may comprise a further interface to be connected to the output of the alternator and in parallel with the regulator.

Block 21, where the CAN network interface is indicated, may comprise a direct interface, for example serial, to a vehicle control unit. Such interface 21 is useful to recover the information connected to dynamic/static errors, to read the charging voltage of the batteries and, possibly, to manage engine start/stop, connection/disconnection of electrical loads and to manage the input/output interface with the operator, when the latter is part of the on-board instruments of the vehicle. The present invention may be performed, at least partially, from a remote server. Thus, both the processing means and the interface means to the vehicle network may comprise remote connection means, such as a data interface (ethernet or serial or wireless or GPRS/UMTS) in order to transfer voltage measures to or to receive commands from a remote server for starting the engine or for the connection of loads and in general for all the operations that may be performed automatically by the system as described above. According to a preferred alternative embodiment of the method, it is performed not only on demand, but also automatically both locally or possibly remotely. Advantageously, thanks to the present invention, not only it is possible to verify the presence of faults in the battery charging system, but possibly also the alterations of the latter that may prejudice its functioning in the future.

Depending on the gravity of the detected alteration, a signal may be immediately sent to the driver by the on-board instruments, or it may be shown only during the routine maintenance. For example, if the efficiency of the alternator is enough to charge the batteries, but is not compliant with quality standards, such condition may be signalled only during the routine maintenance of the vehicle, so that a deeper research may be performed, avoiding a stop of the vehicle.

The present invention may advantageously be realized by means of a computer program, which comprises program code means performing one or more steps of said method, when said program is run on a computer. For this reason the scope of the present patent is meant to cover also said computer program and the computer-readable means that comprise a recorded message, such computer-readable means comprising the program code means for performing one or more steps of such method, when such program is run on a computer.

It will be apparent to the person skilled in the art that other alternative and equivalent embodiments of the invention can be conceived and reduced to practice without departing from the scope of the invention.

The advantages deriving from the use of this invention are evident.

The system automatically performs most of the operations, requiring a limited intervention by a technician, thus the diagnosis procedure of the alternator is standardized, and the result is certified, approving the replacement of the alternator only when it is actually faulty, with a remarkable saving.

From the description set forth above it will be possible for the person skilled in the art to embody the invention with no need of describing further construction details. The elements and the characteristics described in the different preferred embodiments may be combined without departing from the scope of the present application.

## Claims

1. Diagnosis system of the charging apparatus of vehicle batteries (BAT), comprising processing means (20) having:
- interface means (21) and a vehicle data network for acquiring two or more charging voltage measures(+/-) of the vehicle batteries (BAT),
- storing means configured to store said two or more charging voltage measures,
wherein said processing means are configured to compare said two or more charging voltage measures between each other and to at least a lower threshold value, in order to acquire a progression of said charging voltage, **characterised by**
first comparison means (20.1) configured to compare said two or more charging voltage measures between each other to detect a stabilization of said charging voltage (+/-) of the vehicle batteries (BAT) with respect to said lower threshold value, in at least a predetermined interval of time and wherein said processing means (20) further comprise
- human/machine interface means (24) and
- first means configured to promote, by said human/machine interface means, a replacement or the charging of said vehicle batteries (BAT), when said two or more charging voltage measures do not stabilize above said lower threshold value, and
- second means configured to promote, by means of said human/machine interface means (24), a verification of a mechanical connection (T) of the vehicle charging apparatus (G), when said two or more charging voltage measures do not stabilize above said lower threshold value, after having charged or replaced the vehicle batteries (BAT),
and in that the diagnosis system further comprises
- means configured to provide a message (23) certifying a fault of the vehicle configured to generator (G) and/or of a relating regulator/rectifier (R) and configured
- to print said certification message and/or
- to send said certification message to a remote server.

2. System according to claim 1, wherein said processing means comprise:
- second comparison means (20.2) configured to compare said two or more charging voltage measures between each other to detect a ripple of said charging voltage (+/-) of the vehicle batteries (BAT) within a predetermined interval of ripple and/or
- third comparison means (20.3) configured to compare said two or more charging voltage measures between each other to detect a progression of the variation of said two or more charging voltage measures as a function of a variation of an electrical load connected to said vehicle batteries (BAT).

3. System according to claim 2, wherein said first comparison means are configured to detect a stabilization of such two or more charging voltage measures exceeding said lower threshold value and/or lower than an upper threshold value.

4. System according to one of the previous claims from 1 to 3, wherein said processing means (20) further comprise an interface (22) and connection means (S1') to a vehicle wiring (L1) in order to verify the continuity of an electric line (IG, S, L, C) defining said vehicle wiring (L1).

5. System according to any one of the claims from 1 to 4, further comprising first and second remote communication means; said first remote communication means being electrically connected and communicating with said interface means (21) and said second remote communication means being electrically connected with said processing means, in order to perform said diagnosis remotely.

6. Diagnosis method of the charging apparatus of vehicle batteries (BAT) by using the diagnosis system according to claims 1 to 5, comprising the following steps:
- (i) acquisition of two or more charging voltage measures (+/-) of the vehicle batteries (BAT),
- (ii) storing said two or more charging voltage measures,
- (iii) comparison of said two or more charging voltage measures between each other and to at least a lower threshold value, in order to acquire a progression of said charging voltage,
**characterized by** :
- comparison (iv) of said two or more charging voltage measures between each other to detect a stabilization of said charging voltage (+/-) of the vehicle batteries (BAT) with respect to said lower threshold value, in at least a predetermined interval of time and
- promoting (v), by human/machine interface means, a replacement or the charging of said vehicle batteries (BAT), when said two or more charging voltage measures do not stabilize above said lower threshold value, and
- promoting (vi), by means of said human/machine interface means (24), a verification of a mechanical connection (T) of the vehicle generator (G), when said two or more charging voltage measures do not stabilize above said lower threshold value, after having charged or replaced the vehicle batteries (BAT),
- providing (vii) a message (23) certifying a fault of the vehicle charging apparatus (G) and/or of a relating regulator/ rectifier (R) and printing (viii) said certification message and/ or sending (ix) said certification message to a remote server

7. Method according to claim 6, further comprising
- (x) a second comparison of said two or more charging voltage measures between each other to detect a ripple of said charging voltage (+/-) of the vehicle batteries (BAT) within a predetermined interval of ripple and/or
- (xi) a third comparison of said two or more charging voltage measures between each other to detect a progression of the variation of said two or more charging voltage measures as a function of a variation of an electrical load connected to said vehicle batteries (BAT).

8. Method according to claim 7, wherein said second comparison (x) comprises a procedure to detect a stabilization of such two or more voltage measures exceeding said lower threshold value and/or lower than an upper threshold value.

9. Vehicle comprising vehicle batteries (BAT) and a charging apparatus comprising
- a vehicle electric system (L1),
- a generator (G), having
- a mechanical connection (T) and a power takeoff and
- a three-phase electrical output (3V)
- an excitation input (VECC)
- a voltage regulator/rectifier (R) having
- a direct current output (+/-) for recharging the vehicle batteries (BAT),
- an alternate current input (3VR) connected to the three-phase output (3V) of the generator (G) and at least an electric line (IG, S, L, C) connecting to the vehicle electric system (L1),
- measuring means (Vm) of a charging voltage of the batteries;
the vehicle being **characterized in that** it comprises a diagnosis system according to one of the claims from 1 to 5.

10. Computer program comprising program code means suitable for performing all the steps (i - xi) of any claim from 6 to 8, when such program is run on a computer.

11. Computer-readable means comprising a recorded program, said computer-readable means comprising program code means suitable for performing all the steps (i - xi) according to any claims from 6 to 8, when said program is run on a computer.

## Patentansprüche

1. Diagnosesystem für die Ladevorrichtung für Fahrzeugbatterien (BAT), umfassend Verarbeitungsmittel (20) mit:
- Schnittstellenmitteln (21) und einem Fahrzeugdatennetzwerk zur Gewinnung zweier oder mehrerer Ladungsspannungsmessungen (+/-) der Fahrzeugbatterien (BAT),
- Speichermittel vorgesehen zur Speicherung der zwei oder mehreren Ladungsspannungsmessungen,
wobei die Verarbeitungsmittel dazu vorgesehen sind, die zwei oder mehreren Ladungsspannungsmessungen miteinander und mit zumindest einem unteren Grenzwert zu vergleichen, um einen Fortschritt der Ladungsspannung zu ermitteln, **gekennzeichnet durch**
- erste Vergleichsmittel (20.1) vorgesehen zum Vergleich zweier oder mehrerer Ladungsspannungsmessungen miteinander zur Detektion einer Stabilisierung der Ladungsspannung (+/-) der Fahrzeugbatterien (BAT) bezüglich des unteren Schwellwerts, in zumindest einem vorbestimmten Zeitintervall,
wobei die Verarbeitungsmittel (20) ferner umfassen:
- Mensch/Maschine - Schnittstellenmittel (24) und
- erste Mittel vorgesehen zur Beförderung mittels der Mensch/Maschine-Schnittstellenmittel das Einsetzen oder das Laden der Fahrzeugbatterien (BAT), wenn zwei oder mehr Ladungsspannungsmessungen sich nicht oberhalb des unteren Schwellwerts stabilisieren, und
- zweite Mittel vorgesehen zur Förderung mittels der Mensch/Maschine-Schnittstellenmittel (24) einer Verifikation einer mechanischen Verbindung (T) der Fahrzeugladungsvorrichtung (G), wenn die zwei oder mehr Ladungsspannungsmessungen sich nicht oberhalb des unteren Schwellwerts stabilisieren, nachdem die Fahrzeugbatterien (BAT) geladen oder ersetzt worden sind,
wobei das Diagnosesystem ferner umfasst
- Mittel vorgesehen zur Erzeugung einer Nachricht (23), die einen Fehler des Fahrzeuggenerators (G) und/oder eines entsprechenden Reglers/Gleichrichters (R) bestätigt, und dazu vorgesehen sind,
- die Bestätigungsnachricht auszudrucken und/oder
- die Bestätigungsnachricht an einen entfernten Server zu schicken.

2. System gemäß Anspruch 1, bei welchen die Verarbeitungsmittel umfassen:
- zweite Vergleichsmittel (20.2) vorgesehen zum Vergleich zweier oder mehrerer Ladungsspannungsmessungen miteinander zur Detektion einer Welligkeit der Ladungsspannung (+/-) der Fahrzeugbatterien (BAT) innerhalb eines vorbestimmten Wellenintervalls, und/oder
- dritte Vergleichsmittel (20.3) vorgesehen zum Vergleich zweier oder mehrerer Ladungsspannungsmessungen miteinander zur Detektion eines Fortschritts der Veränderung der zwei oder mehrerer Ladungsspannungsmessungen als Funktion einer Veränderung einer elektrischen Last, die an die Fahrzeugbatterien (BAT) angeschlossen ist.

3. System gemäß Anspruch 2, bei welchen die ersten Vergleichsmittel dazu vorgesehen sind, die Stabilisierung der zwei oder mehreren Ladungsspannungsmessungen oberhalb des unteren Schwellwerts und/oder unterhalb eines oberen Schwellwerts zu detektieren.

4. System gemäß einem der vorhergehenden Ansprüche 1 bis 3, bei welchem die Verarbeitungsmittel (20) ferner eine Schnittstelle (22) und Verbindungsmittel (S1') mit einer Fahrzeugverkabelung (L1) umfassen, zur Verifikation des Durchgangs einer elektrischen Leitung (IG, S, L, C), die die Fahrzeugverkabelung (L1) festlegt.

5. System gemäß einem der Ansprüche 1 bis 4, ferner umfassend erste und zweite Fernkommunikationsmittel; welche ersten Fernkommunikationsmittel elektrisch mit den Schnittstellenmitteln (21) verbunden sind und mit diesen kommunizieren, und welche zweiten Fernkommunikationsmittel elektrisch mit den Verarbeitungsmitteln verbunden sind, um eine Ferndiagnose durchzuführen.

6. Diagnoseverfahren mittels der Ladevorrichtung für Fahrzeugbatterien (BAT) unter Verwendung des Diagnosesystems gemäß einem der Ansprüche 1 bis 5, umfassend die folgenden Schritte:
- (i) Ermittlung zweier oder mehrerer Ladungsspannungsmessungen (+/-) der Fahrzeugbatterien (BAT)
- (ii) Speicherung der zwei oder mehreren Ladungsspannungsmessungen,
- (iii) Vergleich der zwei oder mehreren Ladungsspannungsmessungen miteinander und mit zumindest einem unteren Schwellwert zur Ermittlung eines Fortschritts der Ladungsspannung,
**gekennzeichnet durch**:
- Vergleichen (iv) der zwei oder mehreren Ladungsspannungsmessungen miteinander zur Detektion einer Stabilisierung der Ladungsspannung (+/-) der Fahrzeugbatterien (BAT) bezüglich des unteren Schwellwerts in zumindest einem vorbestimmten Zeitintervall, und
- Fördern (v) mittels Mensch/Maschine-Schnittstellenmitteln eines Ersetzens oder Aufladens der Fahrzeugbatterien (BAT), wenn die zwei oder mehr Ladungsspannungsmessungen sich nicht oberhalb des unteren Schwellwerts stabilisieren, und
- Fördern (vi) mittels der Mensch/Maschine-Schnittstellenmittel (24) einer Verifikation einer mechanischen Verbindung (T) des Fahrzeuggenerators (G), wenn die zwei oder mehreren Ladungsspannungsmessungen sich nicht oberhalb des unteren Schwellwerts stabilisieren, nachdem die Fahrzeugbatterien (BAT) geladen oder ersetzt worden sind,
- Erzeugen (vii) einer Nachricht (23) zur Bestätigung eines Fehlers der Fahrzeugladungsvorrichtung (G) und/oder eines entsprechenden Reglers/Gleichrichters (R), und Ausdruck (viii) der Bestätigungsnachricht und/oder Senden (ix) der Bestätigungsnachricht zu einem entfernten Server.

7. Verfahren gemäß Anspruch 6, ferner umfassend:
- (x) einen zweiten Vergleich der zwei oder mehreren Ladungsspannungsmessungen miteinander zur Detektion einer Welligkeit der Ladungsspannung (+/-) der Fahrzeugbatterien (BAT) innerhalb eines vorbestimmten Welligkeitsintervalls, und/oder
- (xi) einen Vergleich der zwei oder mehreren Ladungsspannungsmessungen miteinander zur Detektion eines Fortschritts der Veränderung der zwei oder mehreren Ladungsspannungsmessungen als Funktion einer Veränderung einer elektrischen Last, die an den Fahrzeugbatterien (BAT) anliegt.

8. Verfahren gemäß Anspruch 7, bei welchen der zweite Vergleich (x) einen Vorgang zur Detektion einer Stabilisierung der zwei oder mehreren Ladungsspannungsmessungen oberhalb des unteren Schwellwerts und/oder unterhalb eines oberen Schwellwerts umfasst.

9. Fahrzeug, umfassend Fahrzeugbatterien (BAT) und eine Ladungsvorrichtung, umfassend:
- ein Fahrzeugelektriksystem (L1),
- einen Generator (G), mit
- einer mechanischen Verbindung (T) und einem Leistungsabnehmer und
- einem elektrischen 3-Phasen-Ausgang (3V),
- einem Anregungseingang (VICC)
- einem Spannungsregler/Gleichrichter (R), mit
- einem direkten Stromausgang (+/-) zum Aufladen der Fahrzeugbatterie (BAT),
- einem Wechselstromeingang (3 VR), der mit dem 3-Phasen-Ausgang (3V) des Generators (G) verbunden ist sowie mit zumindest einer elektrischen Leitung (IG, S, L, C) zur Verbindung mit dem Fahrzeugelektriksystem (L1),
- Messmittel (Vm) einer Ladungsspannung der Batterien;
welches Fahrzeug **dadurch gekennzeichnet ist, dass** es ein Diagnosesystem gemäß einem der Ansprüche 1 bis 5 umfasst.

10. Computerprogramm, umfassend Programmcodemittel geeignet zur Durchführung aller Schritte (i - xi) von einem der Ansprüche 6 bis 8, wenn dieses Programm auf einem Computer ausgeführt wird.

11. Computerlesbare Mittel, umfassend ein aufgezeichnetes Programm, welches computerlesbare Mittel Programmcodemittel umfasst, die geeignet sind zur Durchführung aller Schritte (i - xi) gemäß einem der Ansprüche 6 bis 8, wenn dieses Programm auf einem Computer ausgeführt wird.

## Revendications

1. Système de diagnostic de l'appareil de charge de batteries de véhicule (BAT), comprenant des moyens de traitement (20) comportant :
- des moyens formant interface (21) et un réseau de données de véhicule pour acquérir deux mesures ou plus de tension de charge (+/-) des batteries de véhicule (BAT),
- des moyens de mémorisation configurés pour mémoriser lesdites deux mesures ou plus de tension de charge,
dans lequel lesdits moyens de traitement sont configurés pour comparer lesdites deux mesures ou plus de tension de charge entre elles et à au moins une valeur de seuil inférieure, afin d'acquérir une progression de ladite tension de charge, **caractérisé par**
- des premiers moyens de comparaison (20.1) configurés pour comparer lesdites deux mesures ou plus de tension de charge entre elles pour détecter une stabilisation de ladite tension de charge (+/-) des batteries de véhicule (BAT) par rapport à ladite valeur de seuil inférieure, dans au moins un intervalle de temps prédéterminé, et dans lequel
lesdits moyens de traitement (20) comprennent en outre :
- des moyens formant interface homme/machine (24), et
- des premiers moyens configurés pour promouvoir, par lesdits moyens formant interface homme/machine, un remplacement ou la charge desdites batteries de véhicule (BAT), lorsque lesdites deux mesures ou plus de tension de charge ne se stabilisent pas au-dessus de ladite valeur de seuil inférieure, et
- des deuxièmes moyens configurés pour promouvoir, au moyen desdits moyens formant interface homme/machine (24), une vérification d'une liaison mécanique (T) de l'appareil de charge de véhicule (G), lorsque lesdites deux mesures ou plus de tension de charge ne se stabilisent pas au-dessus de ladite valeur de seuil inférieure, après la charge ou le remplacement des batteries de véhicule (BAT),
et en ce que le système de diagnostic comprend en outre :
- des moyens configurés pour fournir un message (23) certifiant un défaut de la génératrice (G) du véhicule et/ou d'un régulateur/redresseur (R) associé, et configurés
- pour imprimer ledit message de certification, et/ou
- pour envoyer ledit message de certification à un serveur à distance.

2. Système selon la revendication 1, dans lequel lesdits moyens de traitement comprennent :
- des deuxièmes moyens de comparaison (20.2) configurés pour comparer lesdites deux mesures ou plus de tension de charge entre elles pour détecter une ondulation de ladite tension de charge (+/-) des batteries de véhicule (BAT) dans un intervalle prédéterminé d'ondulation, et/ou
- des troisièmes moyens de comparaison (20.3) configurés pour comparer lesdites deux mesures ou plus de tension de charge entre elles pour détecter une progression de la variation desdites deux mesures ou plus de tension de charge en fonction d'une variation d'une charge électrique connectée aux dites batteries de véhicule (BAT).

3. Système selon la revendication 2, dans lequel lesdits premiers moyens de comparaison sont configurés pour détecter une stabilisation des deux mesures ou plus de tension de charge dépassant ladite valeur de seuil inférieure et/ou inférieures à une valeur de seuil supérieure.

4. Système selon l'une des revendications 1 à 3 précédentes, dans lequel lesdits moyens de traitement (20) comprennent en outre une interface (22) et des moyens de connexion (S1') à un câblage de véhicule (L1) afin de vérifier la continuité d'une ligne électrique (IG, S, L, C) définissant ledit câblage de véhicule (L1).

5. Système selon l'une quelconque des revendications 1 à 4, comprenant en outre des premiers et deuxièmes moyens de communication à distance ; lesdits premiers moyens de communication à distance étant connectés électriquement et communiquant avec lesdits moyens formant interface (21) et lesdits deuxièmes moyens de communication à distance étant connectés électriquement aux dits moyens de traitement, afin d'effectuer ledit diagnostic à distance.

6. Procédé de diagnostic de l'appareil de charge de batteries de véhicule (BAT) en utilisant le système de diagnostic selon les revendications 1 à 5, comprenant les étapes suivantes :
- (i) acquisition de deux mesures ou plus de tension de charge (+/-) des batteries de véhicule (BAT),
- (ii) mémorisation desdites deux mesures ou plus de tension de charge,
- (iii) comparaison desdites deux mesures ou plus de tension de charge entre elles et à au moins une valeur de seuil inférieure, afin d'acquérir une progression de ladite tension de charge,
**caractérisé par**
- la comparaison (iv) desdites deux mesures ou plus de tension de charge entre elles pour détecter une stabilisation de ladite tension de charge (+/-) des batteries de véhicule (BAT) par rapport à ladite valeur de seuil inférieure, dans au moins un intervalle de temps prédéterminé, et
- la promotion (v), par des moyens formant interface homme/machine, d'un remplacement ou de la charge desdites batteries de véhicule (BAT), lorsque lesdites deux mesures ou plus de tension de charge ne se stabilisent pas au-dessus de ladite valeur de seuil inférieure, et
- la promotion (vi), par lesdits moyens formant interface homme/machine (24), d'une vérification d'une liaison mécanique (T) de la génératrice (G) du véhicule, lorsque lesdites deux mesures ou plus de tension de charge ne se stabilisent pas au-dessus de ladite valeur de seuil inférieure, après la charge ou le remplacement des batteries de véhicule (BAT),
- la fourniture (vii) d'un message (23) certifiant un défaut de l'appareil de charge de véhicule (G) et/ou d'un régulateur/redresseur (R) associé et l'impression (viii) dudit message de certification et/ou l'envoi (ix) dudit message de certification à un serveur à distance.

7. Procédé selon la revendication 6, comprenant en outre :
- (x) une deuxième comparaison desdites deux mesures ou plus de tension de charge entre elles pour détecter une ondulation de ladite tension de charge (+/-) des batteries de véhicule (BAT) dans un intervalle prédéterminé d'ondulation, et/ou
- (xi) une troisième comparaison desdites deux mesures ou plus de tension de charge entre elles pour détecter une progression de la variation desdites deux mesures ou plus de tension de charge en fonction d'une variation d'une charge électrique connectée aux dites batteries de véhicule (BAT).

8. Procédé selon la revendication 7, dans lequel ladite deuxième comparaison (x) comprend une procédure pour détecter une stabilisation des deux mesures de tension ou plus dépassant ladite valeur de seuil inférieure et/ou inférieures à une valeur de seuil supérieure.

9. Véhicule comprenant des batteries de véhicule (BAT) et un appareil de charge comprenant :
- un système électrique de véhicule (L1),
- une génératrice (G), comportant :
- une liaison mécanique (T) et une prise de puissance, et
- une sortie électrique triphasée (3V),
- une entrée d'excitation (VECC),
- un régulateur/redresseur de tension (R) comportant :
- une sortie de courant continu (+/-) pour recharger les batteries de véhicule (BAT),
- une entrée de courant alternatif (3VR) connectée à la sortie triphasée (3V) de la génératrice (G) et à au moins une ligne électrique (IG, S, L, C) connectée au système électrique de véhicule (L1),
- des moyens de mesure (Vm) d'une tension de charge des batteries ;
le véhicule étant **caractérisé en ce qu'**il comprend un système de diagnostic selon l'une des revendications 1 à 5.

10. Programme d'ordinateur comprenant des moyens formant code de programme appropriés pour effectuer toutes les étapes (i à xi) de l'une quelconque des revendications 6 à 8, lorsque ce programme est exécuté sur un ordinateur.

11. Moyens pouvant être lus par un ordinateur comprenant un programme enregistré, lesdits moyens pouvant être lus par un ordinateur comprenant des moyens formant code de programme appropriés pour effectuer toutes les étapes (i à xi) de l'une quelconque des revendications 6 à 8, lorsque ledit programme est exécuté sur un ordinateur.
